# EUROPEAN PATENT APPLICATION

(11) **EP 0 696 159 A1**
(43) Date of publication of application: **07.02.1996**
(21) Application number: 95305430.1
(22) Date of filing: 03.08.1995
(51) Int. Cl.: H05K 3/34

(54) **Printed wiring board**

(30) Priority: 03.08.1994 JP 182395/94
(71) Applicant: International Business Machines Corporation, Armonk, N.Y. 10504 (US)
(72) Inventor: Nakanishi, Tohru, Yasu-cho, Yasu-gun, Shiga-ken (JP); Ohkuma, Hideo, Yasu-gun, Shiga-ken (JP)
(74) Representative: Williams, Julian David

(57) **Abstract**

The invention prevents solder bridges that will easily occur in soldering an element whose leads are narrow in spacing. In a solder resist (20), there is provided an excess-solder absorbing region (24) in which solder resist is not provided, to the distal end of a lead (14) more than an end (22A) of a solder pad (22). When a great deal of solder paste is applied to the solder pad (22) in soldering the lead (14), an excess of solder (28) melted due to the heat of a heater flows along the lead (14) and into the excess-solder absorbing region (24) toward the distal end of the lead (14). Since the excess of solder 28 does not flow across the solder resist (20) provided between the leads (14), no solder bridge is formed.

## Description

The present invention relates to a printed-wiring board and a mounting structure and, more particularly, to a printed-wiring board which is capable of preventing solder bridges that tend to be formed when the spacing of the leads of a surface-mounted element is narrow and a mounting structure which is capable of preventing solder bridges that will take place when leads are repaired with solder.

As seen from the expansion in the market for notebook personal computers, the high-density integration of components has accelerated in recent years. Mounting boards are also no exception, and how components are mounted in a narrow space and how reliability is maintained are becoming very important considerations.

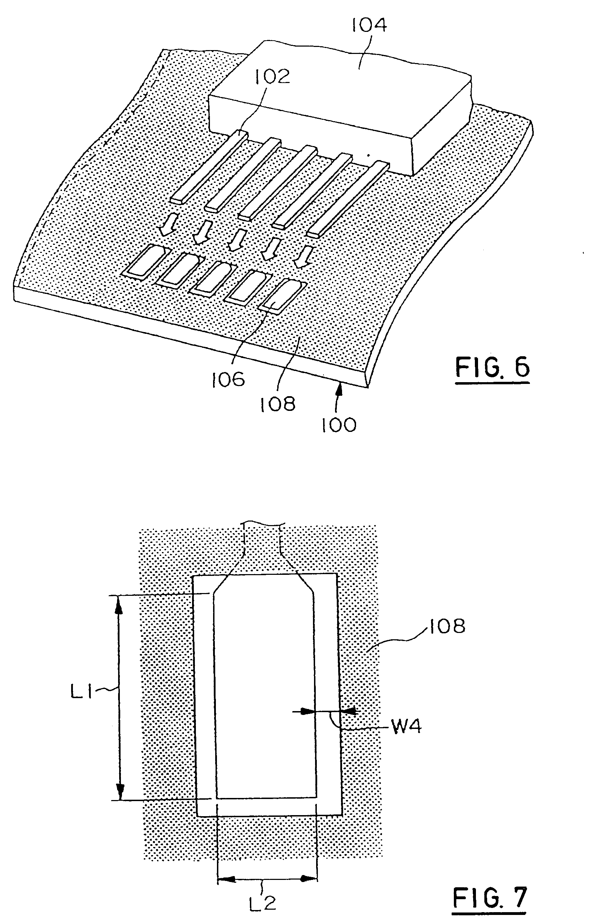

To surface-mount an element 104, e.g., an LSI, having a plurality of leads 102 using solder, a plurality of solder pads 106 is normally arranged on a printed-wiring board 100 at predetermined intervals in accordance with these leads 102, as shown in Figure 6. To avoid electrical contact between adjacent leads 102 through solder bridges in soldering the multiple-lead element 104, a solder resist (portion shaded using dotted lines) 108 is provided around the solder pads 106, as is generally known.

As shown in Figure 7, the size of the solder pad 106 for soldering, for example, the lead 102 having a width of 0.3 mm and a thickness of 0.15 mm is, for example, 1.0 mm in dimension L1 in the longitudinal direction of the lead 102 and, for example, 0.35 mm in dimension L2 in the width direction.

A gap is also, provided around the solder pad 106 to form an opening in the solder resist 108. The width W4 of this gap is 50 µm or so. The gap is provided for absorbing an error in position between the opening of the solder resist 108 and the solder pad 106 but it is not always needed.

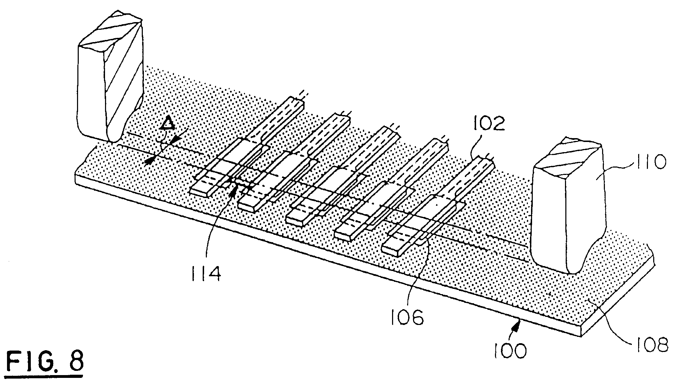

In soldering such elements 104, solder paste is applied to the solder pads 106 of the printed-wiring board 100 by screen printing, etc., the leads 102 are placed on the solder paste on the pads and a heater 110 extending in the direction of the arrangement of the leads 102 is pressed onto the leads 102, and the plurality of leads 102 is soldered at the same time (Figure 8).

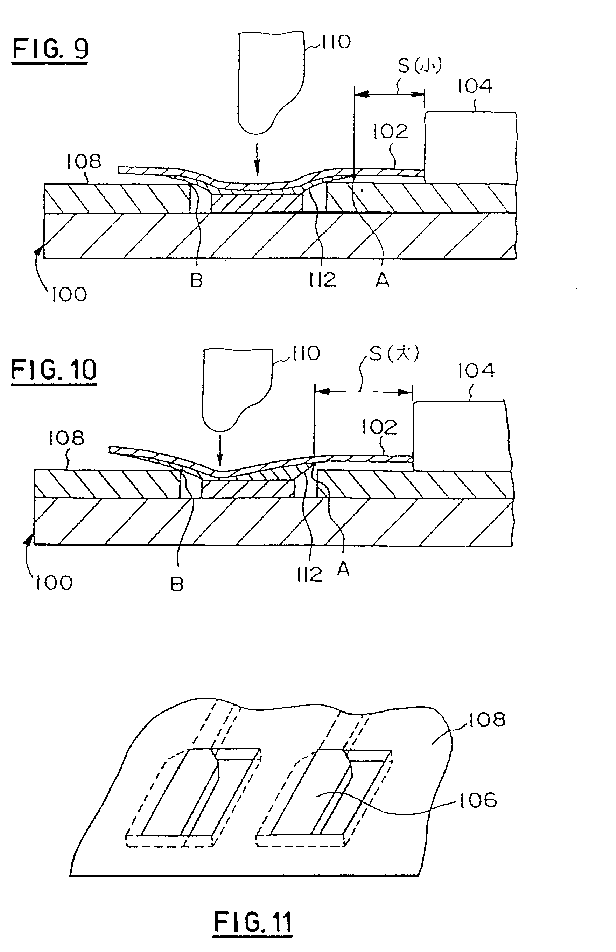

At this point, when the heater 110 presses the centre of the solder pad 106, as shown in Figure 9, a solder fillet 112 is formed into a symmetrical shape with respect to the solder pad 106 in the longitudinal direction of the lead 102, but when the heater 110 presses one end of the solder pad 106 remote from the element 104, as shown in Figure 10, the solder fillet 112 is not a symmetrical shape in the longitudinal direction of the lead 102.

In general, the position at which the heater 110 is applied to the lead 102 is preferably a position as far away as possible from the element 104 to make the thermal and mechanical influence on the element 104 as small as possible and to maintain the flexibility of the lead 102 after soldering. That is, for the flexibility of the lead 102 to be maintained, if the outer end of the solder fillet 112 is assumed to be a fulcrum A, a dimension S from the fulcrum A to the element 104 is preferably longer (Figures 9 and 10). Therefore, for the shape of the solder fillet 112, the asymmetrical shape shown in Figure 10 is preferable to that shown in Figure 9, and the position at which the heater 110 is applied to the lead 102 is normally a position more remote from the element 104 than from the centre of the solder pad 106, as shown Figure 10.

Incidentally, when solder paste is applied by screen printing, the errors of the thickness of the solder paste are about plus or minus 50% or so. As shown in Figure 7, even if the centre of the solder pad 106 and the opening of the solder resist 108 were aligned with each other (even if the positional relationship were the centre of the standard), a solder bridge 114 is sometimes formed when excess solder is applied, as shown in Figure 8. This bridge is normally formed on a side more remote from the element 104 of the solder pad 106 than from the position of the heater 110.

The solder resist 108 is also normally formed by screen printing, so a fluctuation in the thickness is great and an error in the position of the printing also occurs.

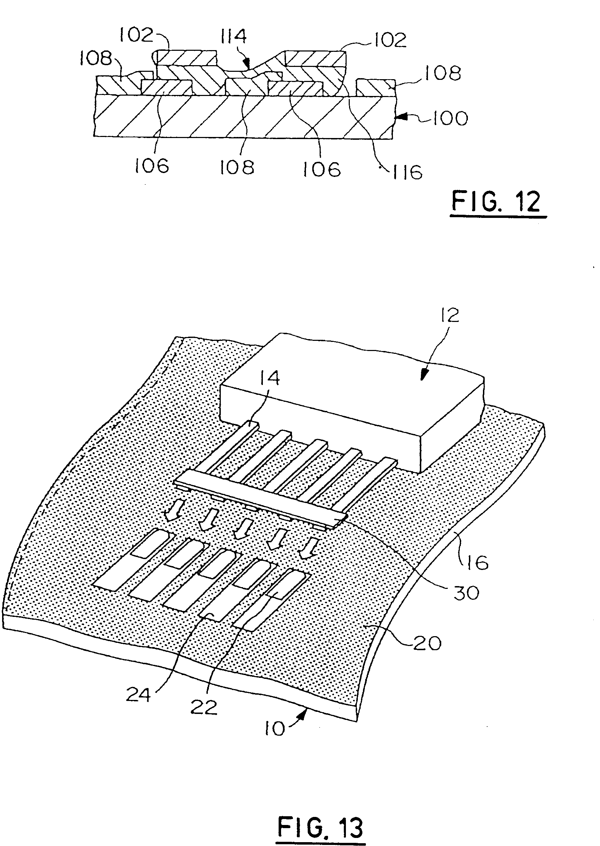

If an error has occurred in position between the solder pad 106 and the solder resist 108 (but, this error in position is within the standard), as shown in Figure 11, solder 116 melted flows to the side of an adjacent lead 102 and a solder bridge 114 is easily formed, as shown in Figure 12, even if the amount of solder applied were appropriate.

Also, if the thickness of the solder resist 108 becomes thinner, melted solder will easily flow across the solder resist 108 and formation of a solder bridge 114 will be promoted.

Further, if the heater 110 is moved farther from the element 104, the probability at which a solder bridge 114 is formed will become higher. This is because, by moving the heater 110 away from the element 104, the heater 110 is moved toward point B of the solder resist 108, as shown in Figure 10, and the lower surface of the lead 102 contacts point B when the lead 102 is pressed down by the heater 110 and therefore excess solder melted is prevented from being bonded beyond point B (when the heater is pressed at a position not so close to point B, the melted solder can flow beyond point B along the lower surface of the lead 102) and, consequently, the melted solder easily flows to the side of the lead 102.

Also, when the lead 102 is pressed down with the heater 110, the lead 102 bends backward because of the repulsion of corner B of the solder resist 108, and the distal end of the lead 102 is lifted up from the printed-wiring board 100 (Figure 10). The bending of the lead 102 becomes greater and greater, as the pressing position of the heater 110 comes closer to the distal end of the lead 102. When such bending of the lead 102 became great, it is conceivable that the distal end of the lead 102 will contact other components, when printed-wiring boards 100 are stacked or when the printed-wiring board 100 comes closer to other components.

As the spacing between leads of an element becomes narrower as is recently the trend, the formation of solder bridges has become easier and a yield is sometimes reduced because of the labour required for repairing solder bridges.

It is certain that such high-density integration of components continues from now on and is further accelerated. In other words, it may safely be said that the occurrence of solder bridges is becoming easier and easier.

Note that various types of methods for preventing solder bridges have so far been proposed. In a printed-wiring board disclosed in PUPA 5-291735, in order to prevent solder bridges, a solder resist is provided between lands, and on that solder resist there is provided another solder resist, and the height is increased by forming solder resists in two layers in this way. This method, however, has the disadvantage that the number of steps for forming solder resist is increased and therefore the cost is increased.

In a printed-wiring board disclosed in Japanese PUPA 60-143690, one solder resist covers a circuit for wiring and another solder resist is provided between the wiring circuit and a pad for surface-mounting. However, in this printed-wiring board, the height of the pad for surface-mounting and the height of the solder resist are the same and, when there is an excess of solder melted, there is a high possibility that solder bridges are caused to occur.

In a printed-wiring board disclosed in Japanese PUPA 60-143690, lands are provided on the sides of foot patterns, and resists are provided around the foot patterns so that they are formed on the lands. Therefore, on the upper surfaces of the lands there are formed resist layers (banks) higher than the foot patterns, and solder bridges are prevented by this resist layer. However, the resist layers higher than the foot patterns are noncontinuous and, when there is an excess of solder melted, there is the possibility that the melted solder flows between the banks and causes solder bridges to occur.

In a printed-wiring board disclosed in Japanese PUPA 59-148388, an ultraviolet-hardened solder resist is provided around a land of an element to which solder is applied, to prevent solder bridges. However, in this printed-wiring board, the height of the solder resist is lower than that of the land and, when there is an excess of solder melted, there is a high possibility that solder bridges are caused to occur.

In a printed-wiring board disclosed in Japanese PUPA 4-359590, a photo-hardened photosolder resist is coated on a circuit board, small space between conductive patterns are collectively covered with an opaque mask film, and exposure hardening of the photosolder resist of the opaque portion is performed in the circuit board by the transmission of light being transmitted through and scattered light. However, the height of the photosolder resist is lower than that of the conductive pattern and, when there is an excess of solder melted, there is a high possibility that solder bridges are caused to occur.

In a printed-wiring board disclosed in Japanese PUPA 2-183595, a solder pad or an opening of a solder resist is formed into a wedge shape to prevent solder bridges. However, when there is an excess of solder melted, there is a high possibility that the melted solder will flow across the solder resist between the solder pads and causes solder bridges to occur.

In a printed-wiring board disclosed in Japanese PUPA 62-74365, in order to prevent solder bridges, a solder resist is provided between lead patterns, insulation coating is printed on the solder resist, and a solder dam with a high surface is formed. This method, however, has the disadvantage in that the number of steps for printing insulation coating is increased, so the cost is increased.

In a printed-wiring board disclosed in Japanese PUPA 1-162279, in order to prevent solder bridges, a solder resist is provided between lead patterns, insulation coating is printed on the solder resist, and a solder barrier is formed. This method, however, has the disadvantage that the number of steps for printing insulation coating is increased, so the cost is increased.

In a printed-wiring board disclosed in Japanese PUPA 2-89878, a solder resist is formed on a circuit board having a plurality of solder pads, and the solder resist covers the edge of each pad and has a plurality of windows through which the centres of the pads are exposed. However, when there is an excess of solder melted, there is a high possibility that the melted solder will flow across the solder resist between the pads and causes solder bridges to occur.

In view of the foregoing facts, there is a requirement to provide a printed-wiring board which is capable of preventing the solder bridges that will easily occur in soldering an element in which the spacing of the leads is narrow, without increasing the number of manufacturing steps, and a mounting structure which is capable of preventing solder bridges that will occur when leads are repaired with solder.

Viewed from one aspect the present invention provides a printed wiring board for mounting an element having a plurality of leads, comprising: a circuit board; a plurality of solder pads provided on the circuit board for positioning and soldering leads of an element to be mounted thereon; a layer of solder resist provided on the circuit board between the solder pads and on a predetermined portion of the circuit board excluding the solder pads for preventing bonding of melted solder; and excess solder absorbing regions positioned adjacent to each solder pad and on which no solder resist is provided so that an excess of melted solder produced in soldering can escape from the solder pads and leads.

Preferably the remaining portion of an opening of said solder resist excluding said solder pad is sized so that it can absorb said excess of melted solder, and said opening includes said excess-solder absorbing region and said solder pad is exposed thorough said opening. When said lead is placed on a predetermined position of said solder pad, said excess-solder absorbing region is opposed to the distal end side of said lead more than to said solder pad. A length of said excess-solder absorbing region measured from its one end remote from said element to one end of said solder pad remote from said element is greater than an allowable error dimension of printing registration of said solder resist added to a length of a portion of said lead extending from said solder pad to one end of said lead remote from said element as said lead is placed on said predetermined position of said solder pad. The element is surface-mounted by soldering said leads of said element to said solder pads of said printed-wiring board.

In order that the invention may be fully understood preferred embodiments thereof will now be described, by way of example only, with reference to the accompanying drawings in which:
Figure 1 is a perspective view of a printed-wiring board and an element of a first embodiment of the present invention before soldering;
Figure 2 is a plan view showing the leads of the element soldered on the solder pads;
Figure 3 is a longitudinal sectional view taken along line 3-3 of Figure 2;
Figure 4 is a perspective view of a printed-wiring board and an element of a second embodiment of the present invention before soldering;
Figure 5 is a perspective view of a printed-wiring board and an element of a third embodiment of the present invention before soldering;
Figure 6 is a perspective view of a conventional printed-wiring board and element before soldering;
Figure 7 is an enlarged view of the solder pad of the conventional printed-wiring board;
Figure 8 is a perspective view of a solder bridge formed in the conventional printed-wiring board;
Figure 9 is a sectional view taken in the longitudinal direction of a lead showing the soldered state as the centre of a solder pad was pressed by a heater;
Figure 10 is a sectional view taken in the longitudinal direction of the lead showing the soldered state as the portion of the solder pad closer to the distal end of the lead than to the centre was pressed by a heater;
Figure 11 is a perspective view of the vicinity of the solder pad showing the state in which there is an error in position between the solder pad and the solder resist;
Figure 12 is a sectional view taken in the width direction of the lead showing the state in which a solder bridge occurred as the lead was soldered to the solder pad shown in Figure 11;
Figure 13 is a perspective view showing a TCP element and a printed-wiring board; and
Figure 14 is a sectional view taken in the longitudinal direction of the lead in the vicinity of the solder pad as the TCP element was soldered to the printed-wiring board.

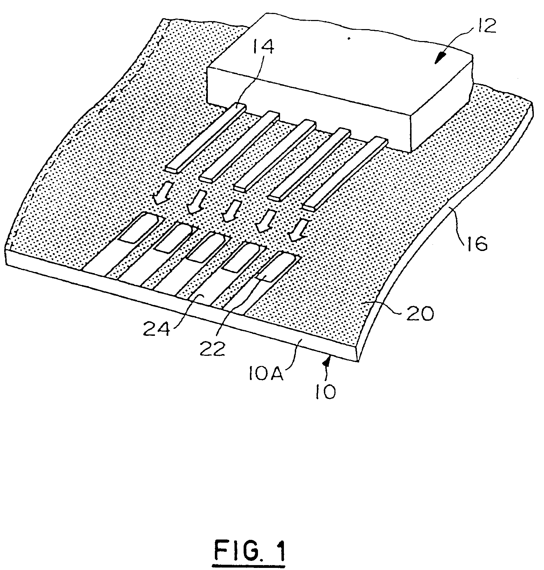

An embodiment of a printed-wiring board of the present invention will be described according to Figures 1 through 8.

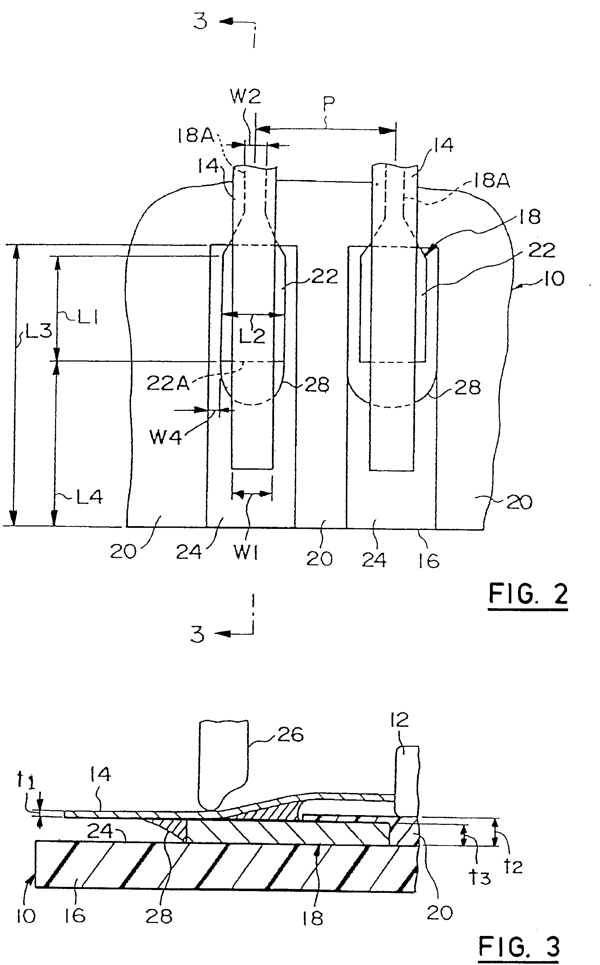

As shown in Figure 1, a plurality of leads 14 projects from the side of an element 12, e.g., an LSI or IC, that will be mounted on a printed-wiring board 10. As shown in Figures 2 and 3, in this embodiment, the thickness t1 (Figure 3) of the lead 14 is 0.15 mm, the width W1 (Figure 2) is 0.3 mm, and the pitch P (Figure 2) is 0.6 mm.

The printed-wiring board 10 is formed on a circuit board 16 with a pattern 18 (in this embodiment, a thickness 30 µm) of a conductor, such as copper leaf.

As shown in Figure 2, a solder pad 22 as a region for soldering the lead 14 is provided at a predetermined position of the pattern 18. The solder pad 22 is a long rectangular shape in the longitudinal direction of the lead 14 and, in this embodiment, a longitudinal dimension L1 in a direction in the longitudinal direction of the lead 14 is 1.0 mm and a lateral dimension L2 in a direction in the width direction of the lead is 0.35 mm. The width W2 of a wiring portion 18A of the pattern 18 continuous to the solder pad 22 is set to 0.1 mm in this embodiment.

Solder resist 20 is provided on the circuit board 16 so that it covers a predetermined region excluding the solder pad 22 of the pattern 18. In this embodiment, the thickness t2 (Figure 3) of the solder resist 20 is 30 to 40 µm.

As shown in Figures 1 and 2, a gap is provided between the longitudinal side and the solder resist 20. This gap is provided for absorbing an error in position between the solder pad 22 and the solder resist 20 and, in this embodiment, the width dimension W4 of the gap is set to 50 µm.

On the side of the distal end of the lead 14 extending from the end 22A of the solder pad 22, there is provided an excess-solder absorbing region 24 in which the solder resist 20 is not provided.

This excess-solder absorbing region 24 is greater than the solder pad 22 by a predetermined dimension. For the size of the excess-solder absorbing region 24 of this embodiment, the width dimension (W4 ^{×} 2 + L2) in a direction in the width direction of the lead 14 is 0.45 mm and the dimension L4 in a direction in the longitudinal direction of the lead 14 is 0.5 mm.

The operation of this embodiment will next be described. First, a predetermined amount of solder paste (not shown) is applied to the solder pad 22 of the printed-wiring board 10 by screen printing.

Next, the element 12 is positioned into a predetermined position on the printed-wiring board 10 so that each lead 14 is opposed to the solder pad 22.

Next, the leads 14 are pressed from above at the same time with a heater 26. Therefore, as shown in Figure 3, the lead 14 is bent downward by the heater 26 and also the solder paste is melted. After 2 to 3 seconds, the electricity to the heater 26 is stopped, cooling air is applied toward the lead 14, and the solder 28 is hardened, so the solder pad 22 and the lead 14 are connected (soldered). Thereafter, the heater 26 is moved upward.

Since the distal end of the lead 14 corresponds to the excess-solder absorbing portion 24 and the lower surface of the lead 14 is by no means brought into contact with the solder resist 20, there is no possibility that the lead 14 is bent backward when pressed by the heater 26 and the distal end of the lead is bent in a direction away from the printed-wiring board 10. Therefore, the distal end of the lead 14 does not contact, for example, any other component (not shown) over the printed-wiring board 10.

Also, even if a great deal of solder paste were applied to the solder pad 22, an excess of solder 28 melted due to the heat of the heater 26 would flow along the lead 14 and into the excess-solder absorbing region 24 toward the distal end of the lead 14 (see the right-hand lead 14 shown in Figure 2, note that in the left-hand lead 14 the amount of solder is almost an appropriate amount).

Therefore, there is no possibility that an excess of the solder 28 melted rises above the surface of the solder resist 20 and flows across the solder resist 20 between the leads 14 to form a so-called solder bridge.

For the size of the excess-solder absorbing region 24, a conceivable maximum amount of solder paste is applied to the solder pad 22, a lowest size at which solder bridges do not occur is measured by actually soldering before mass production, and then the size of the region 24 is preferably to be set to a sufficient size greater than the area of the measured lowest size. Note that, as a rough criterion, the area of the excess-solder absorbing region 24 {= L4 ^{×} (W4 ^{×} 2 + L2)} is preferably more than 50% of the area of the solder pad 22. This is a rough criterion, however, so the area of the excess-solder absorbing region 24 changes depending on how much excess solder is produced in the manufacturing process.

It is to be noted that, precisely speaking, the volume of a space that the volume of the pattern 18 in the opening of the solder resist 20 (almost equal to L1 ^{×} L2 ^{×} t3) is subtracted from the volume of the opening of the solder resist 20 {= (W4 ^{×} 2 + L2) ^{×} L3 ^{×} t2}, is a volume that can absorb an excess of the solder 28 with reliability.

Thus, in the printed-wiring board 10 of this embodiment, even if there were a great deal of solder, solder bridges could be reliably prevented because an excess of solder melted can escape into the excess-solder absorbing region 24. Also, even if the pitch P between the leads 14 becomes narrower in future, an occurrence of solder bridges can be prevented.

Note that a structure in which the element 12 is soldered and mounted on the printed-wiring board 10 is a mounting structure.

Also, as a method of applying solder (paste) to the solder pad 22 there are a method of applying solder by electroplating and a method of applying solder by electroless plating, but these methods require complicated equipment and are expensive, as compared to the screen printing method employed in this embodiment.

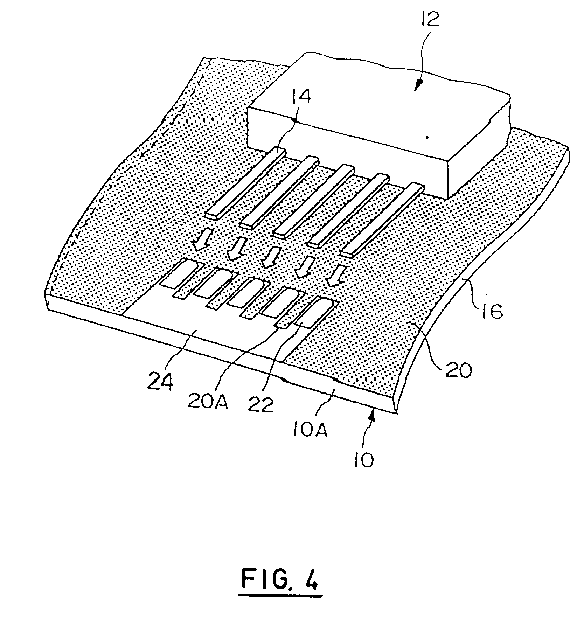

A second embodiment of the present invention will be described according to Figure 4. The same reference numerals will be applied to the same constitution as the first embodiment and therefore a description thereof will be omitted here.

In a printed-wiring board 10 of this embodiment, a solder resist 20 provided between leads 14 terminates short of an end 10A of a printed-wiring board 10. As with the first embodiment, this embodiment also can prevent solder bridges.

It is to be noted that an end 20A of the solder resist 20 provided between the leads 14 is preferably positioned beyond at least a solder pad 22 toward the distal end of the lead 14. Also, the end 20A of the solder resist 20 is set after it has been proven by experiment that an excess of solder 28 melted does not contact the end 20A.

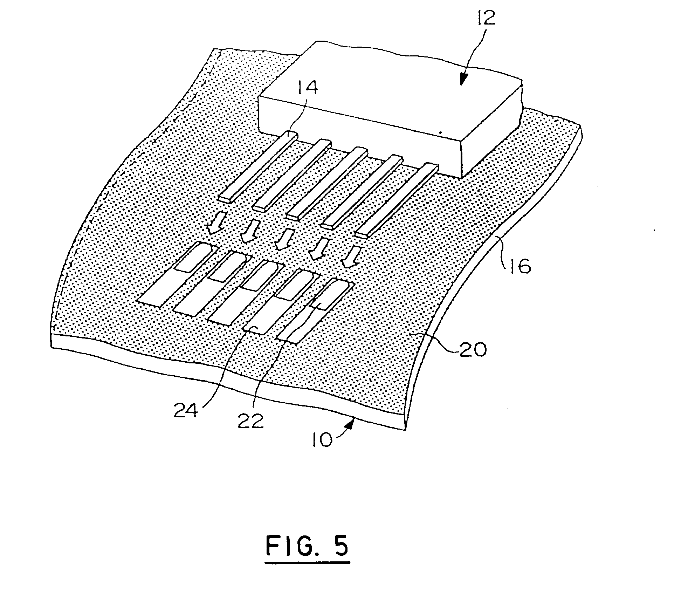

A third embodiment of the present invention will be described according to Figure 5. The same reference numerals will be applied to the same constitution as the first embodiment and therefore a description thereof will be omitted here.

In this embodiment, there is shown an example of a case where an element 12 (not shown in Figure 5) is disposed, for example, in the vicinity of the centre of a printed-wiring board 10.

This embodiment can also prevent solder bridges if, as a rough criterion, the area of an excess-solder absorbing region 24 is set to more than 50% of the area of a solder pad 22. Note that this is a rough criterion, so the area of the excess-solder absorbing region 24 changes depending on how much excess solder is produced in the manufacturing process.

It is to be noted that a solder resist 20 is printed on a pattern 18, so a positional error sometimes occurs between the solder pad 22 and the solder resist 20. The dimensions of the excess-solder absorbing region 24 are preferably set so that, even if the maximum positional error within a standard occurs, a lead 14 projecting from the solder pad 22 would be opposed to the excess-solder absorbing region 24 at all times.

In this embodiment, since the maximum error in position between the solder pad 22 and the solder resist 20 is assumed to be 0.1 mm, the dimensions of the excess-solder absorbing region 24 are preferable to be set in view of a dimension greater than 0.1 mm.

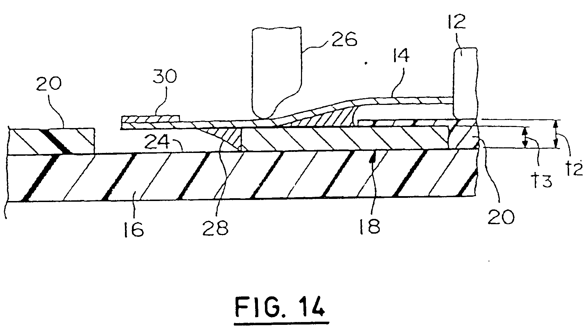

A fourth embodiment of the present invention will be described according to Figures 13 and 14. The same reference numerals will be applied to the same constitution as the first embodiment and therefore a description thereof will be omitted here.

Some of the elements 12 are called a tape carrier package (TCP). When this type of element 12 is soldered, the leads 14 of the element 12 are easily damaged and deformed because they are very thin.

For this reason, reinforcing tape 30 is attached to the distal ends of the leads 14 to prevent the deformation of the leads 14, as shown in Figure 13.

This reinforcing tape 30 is normally made from a polyamide material, poor in heat conduction, and reduces the rate of heat conduction from the heater 26 to solder, and not good for soldering, so it is as far as possible away from solder so that it does not contact the heater 26.

In a conventional printed-wiring board of this kind, there was the problem that an excess of solder melted is blocked by the reinforcing tape and therefore flows to an adjacent lead along the reinforcing tape, so solder bridges are easily formed. However, since in the printed-wiring board 10 of the present invention an excess of solder melted can flow into the excess-solder absorbing region 24, solder bridges can be prevented even if the reinforcing tape 30 were provided on the leads 14.

It is to be noted that the relationship of dimensions in the above-described embodiment is merely an example. Needless to say, the dimensions of the excess-solder absorbing region 24 can be changed according to the dimensions of the lead 14 and the solder pad 22.

Also, in a mounting structure in which an element is mounted on the printed-wiring board described in the above embodiments, soldering is sometimes performed again in the repair and replacement of elements. In this case, there is also the possibility that an excess of melted solder is produced when there is a great deal of solder. However, in such a case, solder bridges can also be prevented in element repairs because an excess of melted solder is absorbed by the excess-solder absorbing region.

As has been described hereinbefore, the printed-wiring board has the advantage that, even if there were an excess of solder, solder bridges could be prevented because melted solder can flow into the excess-solder absorbing region provided on the side of the solder pad remote from the element.

The printed-wiring board has the excellent advantage that all of an excess of melted solder can be absorbed by the remaining of an opening of the solder resist excluding the solder pad. The opening includes said excess-solder absorbing region and said solder pad is exposed through said opening.

The printed-wiring board has the excellent advantage that the distal end of the lead can be prevented from being lifted up from the printed-wiring board when the lead is soldered by the heater, and also the distal end of the lead can be prevented from contacting other components, because the distal end of the lead projecting from the solder pad is opposed to the excess-solder absorbing region.

The printed-wiring board has the excellent advantage that, even if there occurred an error in position between the solder pad and the solder resist to be printed, the distal end of the lead could be prevented from being lifted up from the printed-wiring board when the lead is soldered by the heater and also the distal end would not contact other components, because the length of said excess-solder absorbing region measured from its one end remote from said element to one end of said solder pad remote from said element is greater than the allowable error dimension of printing registration of said solder resist added to a length of a portion of said lead extending from said solder pad to one end of said lead remote from said element as said lead is placed on said predetermined position of said solder pad.

The mounting structure as set forth in Claim 5 has the excellent advantage that an excess of melted solder produced in the solder repair of the lead is absorbed by the excess-solder absorbing region and therefore solder bridges can be prevented because the element is surface-mounted by soldering the lead to the solder pad adjacent to the excess-solder absorbing region.

In the printed-wiring board described above, a predetermined amount of solder paste is applied to a plurality of solder pads by screen printing, etc. Next, an element having a plurality of long leads is disposed in a predetermined position of the printed-wiring board so that each lead is opposed to each solder pad. In this state, by pressing the plurality of leads at the same time by a heater, solder is melted and the leads are soldered to the solder pads.

Incidentally, when there is a great deal of solder paste applied, an excess of melted solder is generated due to the pressing of the heater, but this excess of melted solder flows along the lead (mainly the lower surface) into the excess-solder absorbing region provided on the side of the solder pad remote from the element. Therefore, solder bridges that will be caused by an excess of solder can be prevented with reliability.

Since the remaining portion of an opening of said solder resist excluding said solder pad is sized so that it can absorb said excess of melted solder, the excess of melted solder can be absorbed by said remaining portion. The opening includes said excess-solder absorbing region and said solder pad is exposed through said opening.

The distal end of the lead projecting from the solder pad is opposed to the excess-solder absorbing region. For this reason, when the lead is pressed from above toward the solder pad by the heater, the lower surface of the distal end of the lead can be prevented from contacting the solder resist. For this reason, there is no possibility that the lead is bent backward and the distal end of the lead is lifted up from the printed-wiring board.

Even if there occurred an error in position between the solder pad and the solder resist to be printed, the lower surface of the distal end of the lead would not contact the solder resist, because the length of said excess-solder absorbing region measured from its one end remote from said element to one end of said solder pad remote from said element is greater than an allowable error dimension of printing registration of said solder resist added to a length of a portion of said lead extending from said solder pad to one end of said lead remote from said element as said lead is placed on said predetermined position of said solder pad.

Since the element is surface-mounted by soldering the lead to the solder pad adjacent to the excess-solder absorbing region, an excess of melted solder produced in the solder repair of the lead is absorbed by the excess-solder absorbing region and therefore solder bridges can be prevented.

## Claims

1. A printed wiring board for mounting an element having a plurality of leads, comprising:
a circuit board;
a plurality of solder pads provided on the circuit board for positioning and soldering leads of an element to be mounted thereon;
a layer of solder resist provided on the circuit board between the solder pads and on a predetermined portion of the circuit board excluding the solder pads for preventing bonding of melted solder; and
excess solder absorbing regions positioned adjacent to each solder pad and on which no solder resist is provided so that an excess of melted solder produced in soldering can escape from the solder pads and leads.

2. A printed wiring board as claimed in claim 1 wherein the excess solder absorbing region is positioned on the opposite side of the solder pad from the area on which an element is to be mounted.

3. A printed wiring board as claimed in claim 1 or claim 2 wherein the remaining portions of the openings of the solder resist excluding the solder pads are sized such that they can absorb an excess of melted solder, and the openings include the excess solder absorbing regions and the solder pads are exposed through the openings.

4. A printed wiring board as claimed in claim 2 or claim 3 wherein the length of the excess solder absorbing region measured between the end remote from the area on which an element is to be mounted and the end of the solder pad remote from the element area is greater than an allowable error dimension of printing registration of solder resist added to a length of a portion of a lead extending from a solder pad to one end of the lead remote from an element when the lead is placed on the predetermined position of the solder pad.

5. A mounting structure including a printed wiring board as claimed in any of claims 1 to 4 and at least one element surface mounted to the board by soldering leads of the element to solder pads of the board.
